Europäisches Patentamt

European Patent Office

Office européen des brevets

(19)

(11) Veröffentlichungsnummer: **0 002 516**
**B1**

(12) **EUROPÄISCHE PATENTSCHRIFT**

(45) Veröffentlichungstag der Patentschrift: **15.09.82**

(21) Anmeldenummer: **78101642.3**

(22) Anmeldetag: **12.12.78**

(51) Int. Cl.³: **H 01 L 21/68,** B 65 H 3/08,
B 65 G 47/91

(54) Vakuumkopf für flache, dünne Werkstücke.

(30) Priorität: **12.12.77 US 859778**

(43) Veröffentlichungstag der Anmeldung:
**27.06.79 Patentblatt 79/13**

(45) Bekanntmachung des Hinweises auf die Patenterteilung:
**15.09.82 Patentblatt 82/37**

(84) Benannte Vertragsstaaten:
**DE FR GB**

(56) Entgegenhaltungen:
**DE - B - 1 205 908**
**DE - C - 1 112 538**

**IBM TECHNICAL DISCLOSURE BULLETIN, Band
19, August 1976, New York, USA, H. A.
GOODMAN et al., "Wafer chuck", Seiten 943—
944**

(73) Patentinhaber: **International Business Machines
Corporation**
**Armonk, N.Y. 10504 (US)**

(72) Erfinder: **Buchmann, Albert Henry**
**Route 10 Idylwild**
**Richmond Kentucky 40475 (US)**
Erfinder: **Cochran, Thomas John**
**Square Woods Drive**
**LaGrangeville New York 12540 (US)**
Erfinder: **Ficker, Walter William**
**17 Birch Street**
**Fishkill New York 12524 (US)**
Erfinder: **Stricker, Alfred Alois**
**1903 Bay Drive**
**Pompano Beach Florida 33062 (US)**
Erfinder: **von Kaenel, Walter**
**510 SE 13th Street**
**Pompano Beach Florida 33060 (US)**

(74) Vertreter: **Willich, Wolfgang, Dipl.-Ing.**
**Schönaicher Strasse 220**
**D-7030 Böblingen (DE)**

Vakuumkopf für flache, dünne Werkstücke

Vakuumköpfe dieser Art dienen allgemein zum Erfassen und Transportieren von Werkstücken, die eine flache Oberfläche aufweisen und wegen ihrer plattenförmigen Gestalt mit anderen Werkzeugen, wie Greifer- oder Klemmvorrichtungen, nicht oder nur schwer erfaßt werden können.

Besonders geeignet sind Vakuumköpfe insbesondere auch bei Herstellprozessen für Schaltungen der Datenverarbeitungstechnik, nämlich bei der Verarbeitung plattenförmiger Elemente zur Herstellung von Halbleitereinheiten. Bei diesen Elementen handelt es sich beispielsweise um Halbleiterscheiben, sogenannte Wafer, oder um sogenannte grüne keramische Folien, das heißt dünne, biegsame, papierähnliche Folien, die zur Herstellung mehrschichtiger, keramischer Halbleiterpackungen dienen. Zur Herstellung derartiger Halbleiterpackungen werden die Folien in kleine Stücke zerschnitten und durch Herstellen von durchgehenden Bohrungen sowie Ausfüllen dieser Bohrungen mit einer elektrisch leitenden Paste und Aufdrucken eines Leitungsmuster weiter verarbeitet. Eine Anzahl derartig verarbeiteter Folienelemente wird dann zusammengefügt, gepreßt, geschnitten und anschließend gesintert. Auf die Oberseite und die Unterseite des so hergestellten keramischen Substrats werden dann entsprechende Metallisierungen aufgebracht und die entsprechenden Verbindungen über die zuvor in den Folienelementen hergestellten, durchgehenden Bohrungen hergestellt. Anschließend werden die elektrischen Anschlüsse und Halbleitervorrichtung angebracht und das Ganze eingekapselt.

Die manuelle Handhabung der sogenannten grünen keramischen Folien und ihr Aufeinanderschichten erfordert ein hohes Maß an Geschicklichkeit und ist immer wieder mit Beschädigungen der Folienelemente verbunden. Denn bei einer Dicke von etwa 0,2 mm und einer im Verhältnis zur Dicke sehr großen Fläche besteht für die Folienelemente bei ihrer Handhabung die Gefahr der Verformung, des Bruches oder einer sonstigen Beschädigung. Außerdem kann das Berühren der mit leitenden Bereichen beschichteten Flächen mit den Händen eine Beeinträchtigung der Funktion, unter Umständen mit der Folge der Unbrauchbarkeits des Elements, zur Folge haben.

Ein weiteres Problem bei der Handhabung derartiger dünner, plattenförmiger Werkstücke, wie Folienelemente, ist das präzise Ausrichten des Elements, etwa zu einer Maske zum Zwecke der Herstellung des gewünschten Leitungsmusters und zum Ausfüllen der Bohrungen, sowie das Ausrichten der Folienelemente und der Zwischenlagen zur Bildung eines mehrschichtigen Stapels.

Der Erfindung liegt die Aufgabe zu Grunde, einen Vakuumkopf zu schaffen, der die hohen Anforderungen bei der Handhabung von Elementen der vorher beschriebenen Art zu erfüllen vermag und sich für den Einsatz zum Erfassen und Transportieren sowie Ausrichten von Halbleiterelementen, insbesondere Folienelementen und Zwischenlagen, in besonderem Maße eignet. Diese Aufgabe ist erfindungsgemäß durch die im Patentanspruch 1 gekennzeichnete Ausbildung gelöst worden.

Durch die DE—PS 11 12 538 ist ein Vakuumkopf bekannt, aus dessen Anlagefläche Fühlstifte herausragen, welche beim Aufsetzen des Vakuumkopfes, z. B. auf eine Briefsendung, in die Saugfläche hineingedrückt werden und die Abwärtsbewegung des Kopfes unterbrechen, bzw. eine andere Funktion auslösen, z. B. einen Ventilschieber betätigen. Diese bekannte Anordnung dient zum automatischen Verarbeiten, insbesondere zum Vereinzeln von Postsendungen.

Der nach der Erfindung ausgebildete Vakuumkopf gewährleistet das Anliegen des Werkstücks an der Anlagefläche, nämlich im peripheren Bereich des Werkstücks, während durch die zentrale Werkstückfläche im Zusammenwirken mit dem zentralen Bereich des Vakuumkopfes eine Art Vakuumkammer gebildet wird, bei welcher das Werkstück gewissermaßen als Membran wirksam ist. Auf diese Weise erfolgt eine wirksame Halterung auch des mittleren Bereichs der Werkstückfläche. Eine vorteilhafte Ausgestaltung des erfindungsgemäßen Vakuumkopfes ist, daß mittels der Fühlstifte jeweils ein Signal zur Verfügung steht, zur Anzeige, welche Gattung von Werkstück jeweils vom Vakuum erfaßt worden ist, indem jeweils nur diejenigen Fühlstifte der Abfühlvorrichtungen betätigt werden, welche nicht in ein im Werkstück an definierter Position vorgesehenes Loch eindrigen können.

Das im folgenden anhand der Zeichnungen beschriebene Ausführungsbeispiel ist für Werkstücke der vorgenannten Art von quadratischer oder rechteckiger Form gestaltet. Es sind aber selbstverständlich auch andere Konturen des Vakuumkopfes in Anpassung an die Werkstückform denkbar, wie z. B. für kreisrunde, ovale oder ähnliche Werkstücke.

Es zeigen:

Fig. 1 eine schaubildliche Gesamtansicht eines Vakuumkopfes von unten, mit einem gebrochen dargestellten Teilbereich,

Fig. 2 eine vergrößerte Schnittansicht in der Ebene 2—2 der Fig. 1,

Fig. 3 eine schaubildliche Teildarstellung des Vakuumkopfes gemäß Fig. 1, in schräger Draufsicht,

Fig. 4 eine vergrößerte Detaildarstellung der Schlitze an der Auflagefläche des Vakuumkopfes gemäß Fig. 1.

Fign. 5A u. 5B vergrößerte Schnittdarstellungen der in Fig. 2 gezeigten Rückschlagventile unter verschiedenen Druckbedingungen.

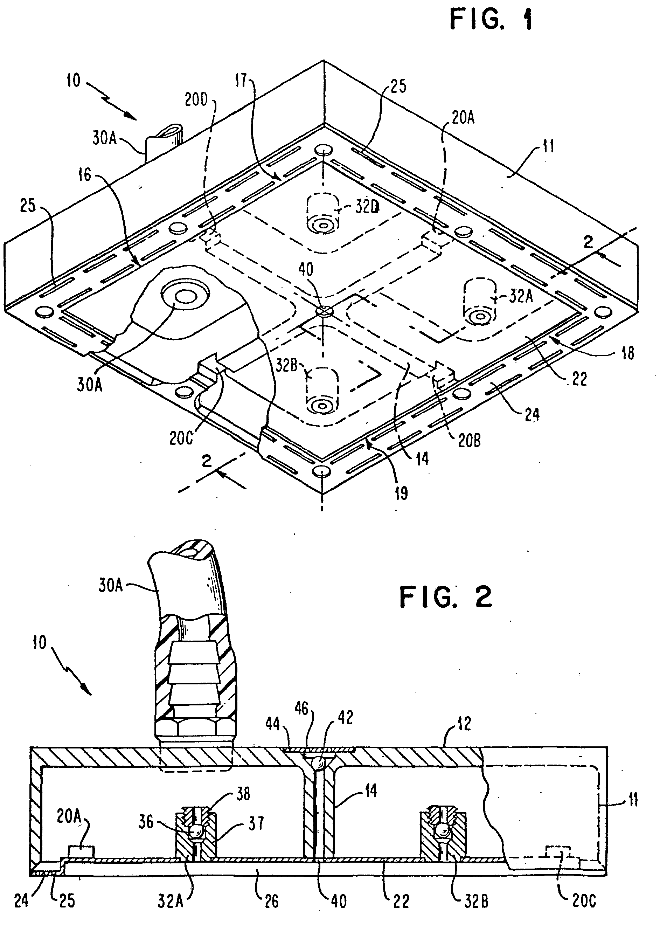

Der in den Fign. 1 bis 3 dargestellte Vakuumkopfe 10 enthält Seitenwände · 11, eine im wesentlichen quadratische obere Wand 12 und ein Rahmenkreuz 14, welches vier Teilkammern 16, 17, 18 und 19 bildet. Durchlässe 20A bis 20D in den Armen des Rahmenkreuzes 14 bilden Verbindungen zwischen den Teilkammern 16 bis 19. Die durch die Teilkammern 16 bis 19 gebildete Hauptkammer wird nach unten durch eine Bodenwand 22 abgeschlossen, die bezüglich einer an der Peripherie der Seitenwände 11 befindlichen Anlagefläche 24 etwas zurückgesetzt ist.

In der Anlagefläche 24 befindliche Schlitze 25 dienen dazu, daß das in den Teilkammern 16 bis 19 befindliche Vakuum oder der dort herrschende Überdruck durch die Anlagefläche 24 hindurch auf das dort jeweils anliegende Werkstück wirksam wird. Durch das Anliegen eines plattenförmigen Werkstücks an der Anlagefläche 24 wird im Zusammenhang mit der Bodenwand 22 in einem Bereich 26 eine Kammer gebildet, die bei Einwirkung von Unterdruck als Vakuumkammer wirksam ist und die durch die Schlitze 25 hindurch wirksamen Haltekräfte unterstützt.

Zur gleichmäßigen Verteilung zugeführten Vakuums oder Überdrucks führen zu den Teilkammern 16 bis 19 Luftleitungen 30A bis 30D durch die obere Wand 12 hindurch. Die Luftleitungen 30A bis 30D sind an entsprechende, auf Unterdruck oder Überdruck umschaltbare (nicht gezeigte) Zuleitungen angeschlossen. Weiterhin sind Rückschlagventile 32A bis 32D zwischen den einzelnen Teilkammern 16 bis 19 und dem Bereich 26 angeordnet.

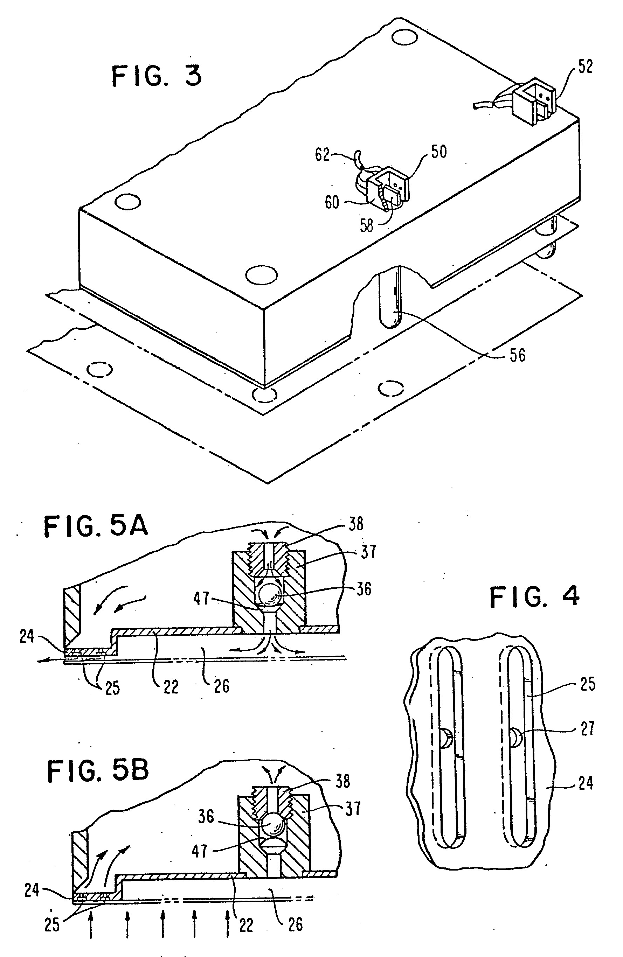

Jedes der Rückschlagventile 32A bis 32D enthält ein Kugel 36 in einem Gehäuse 37 mit einem axialen Kanal, in den ein Schraubeinsatz 38 eingeschraubt ist und eine Anlagefläche für die Kugel 36 bildet. Eine Federscheibe 47 ist auf die Kugel 36 so wirksam, daß das Ventil geschlossen ist, solange sich in der durch die Teilkammern 16 bis 19 gebildeten Hauptkammer kein Überdruck befindet. Steht die Hauptkammer unter Überdruck, so öffnet sich, wie Fig. 5A zeigt, das Ventil, und es kann Luft aus der Hauptkammer in den Bereich 26 ausströmen. Solange jedoch in der Hauptkammer Unterdruck herrscht, liegt die Kugel 36, wie Fig. 5B zeigt, unter der Wirkung des Vakuums sowie der Federscheibe 47 am Schraubeinsatz 38 an, und das betreffende Rückschalgventil ist daher geschlossen. In diesem Fall bildet das an der Anlagefläche 24 anliegende Werkstück somit im Bereich 26 eine Vakuumkammer, unter deren Wirkung es festgehalten wird.

Im zentralen Bereich des Rahmenkreuzes 14 besteht gemäß den Fign. 1 und 2 mittels eines Entlüftungskanals 40 eine Leitungsverbindung zwischen der Oberseite der oberen Wand 12 und dem Bereich 26. In einer Konusführung am oberen Ende des Entlüftungskanals 40 befindet sich eine Kugel 42, die mittels einer Scheibe 44 abgedeckt und gegen Herausfallen gesichert ist. In der Scheibe 44 befinden sich Entlüftungsbohrungen 46. Wenn die Rückschlagventile 32A bis 32D infolge des in der Hauptkammer wirksamen Unterdrucks geschlossen sind (Fig. 5B), die im Bereich 26 gebildete Kammer somit unter einem gewissen Unterdruck steht, ist der Entlüftungskanal 40 durch die Kugel 42 verschlossen. Herrscht dagegen in der Hauptkammer Überdruck, so hebt sich die Kugel 42 nach oben von ihrem Schließsitz ab und ermöglicht ein Entlüftung des Bereichs 26.

In Fig. 3 ist der Vakuumkopf gemäß Fig. 1 mit zwei Abfühlvorrichtungen 50 und 52 dargestellt, welche zur Erkennung von unterschiedlichen, vom Vakuumkopf erfaßten Werkstücken dienen. Jede der Abfühlvorrichtungen 50, 52 weist einen Fühlstift 56 auf, welcher durch entsprechende Bohrungen in der Anlagefläche 24 hindurchragt und das Vorhandensein eines Werkstücks an der Anlagefläche 24 abtastet.

Ist der Fühlstift 56 einer der Abfühlvorrichtungen 50, 52 infolge des Anlegens eines Werkstücks an der Anlagefläche 24 in seine obere Lage verstellt, so erzeugt ein Kopfteil 58 des Fühlstiftes 56 in Verbindung mit einem Magnetjoch 60 ein elektrisches Signal, welches über Leitungen 62 zu einer entsprechenden Auswertungsschaltung (nicht gezeigt) übermittelt wird.

Zur Unterscheidung unterschiedlicher Werkstücke, z. B. Folienelementen einerseits und Zwischenlagen andererseits, wie sie beispielsweise bei der Herstellung mehrschichtiger Schaltungspakete abwechselnd aufeinandergeschichtet werden, ist die eine Art Werkstücke mit Löchern an bestimmten Positionen und die andere Werkstücke mit Löchern an bestimmten anderen Positionen versehen, wobei die Lage der Positionen mit derjenigen der Fühlstifte 56 übereinstimmt. Zur Unterscheidung der beiden Werkstückarten genügt je eine Abfühlvorrichtung, z. B. die Abfühlvorrichtung 50 für Folienelemente und die Abfühlvorrichtung 52 für Zwischenlagen, wobei das jeweils zu identifizierende Werkstück an der betreffenden Position der zugeordneten Abfühlvorrichtung kein Loch aufweist. Zweckmäßigerweise werden jedoch eine Mehrzahl von Abfühlvorrichtungen angeordnet, z. B. für die Zwischenlagen je eine Abfühlvorrichtung 52 an den Ecken und für die Folienelemente je eine Abfühlvorrichtung 50 in den Bereichen zwischen den Ecken, wie in Fig. 3 angedeutet.

Die Schlitze 25 in der Anlagefläche 24 sind gemäß Fig. 4 verhältnismäßig lang ausgebildet und nur in ihrem zentralen Bereich durch kleine Bohrungen 27 mit den Teilkammern 16 bis 19 der Hauptkammer verbunden. Die Größe der Schlitze 25 und der Bohrungen 27 ist entsprechend der Größe und dem Gewicht der Werkstücke sowie entsprechend dem angewendeten Vakuumpegel bemessen. Die Breite der Schlitze 25 kann beispielsweise unter 1 mm betragen.

Zur Aufnahme eines Werkstücks von einer Unterlage oder von einem Stapel wird der dargestellte Vakuumkopf 10 über das Werkstück bewegt und auf dasselbe abgesenkt. Nun wird Unterdruck eingeschaltet, so daß das Werkstück mit seinem peripheren Bereich an der Anlagefläche 24 anliegt und gleichzeitig der zentrale Bereich des Werkstücks durch den sich im Bereich 26 bildenden Unterdruck festgehalten wird. Nun wird der Vakuumkopf 10 angehoben und zur Ablageposition des Werkstücks befördert. Die von den Abfühlvorrichtungen 50 bzw. 52 abgegebenen Signale zeigen an, welche Art Werkstück sich am Vakuumkopf 10 befindet, z. B. ob es sich um ein Folienelement oder um eine Zwischenlarge handelt, je nachdem, an welchen Positionen des betreffenden Werkstücks Löcher vorgesehen sind. Gleichzeitig kann mittels der Abfühlvorrichtungen 50 bzw. 52 geprüft werden, ob sich das abgehobene Werkstück in der richtigen Lage zum Vakuumkopf 10 befindet.

Zum Ablegen des Werkstücks an seiner Zielposition wird die Unterdruckzufuhr abgeschaltet und der Vakuumkopf 10 auf Überdruck umgeschaltet. Man kann das Ablösen auch unterstützen, indem die Fühlstifte 56 durch einen gleichzeitig eingeschalteten Antrieb in ihre untere Lage verschoben werden. Der Vakuumkopf 10 in der beschriebenen Ausbildung kann aber auch dazu eingesetzt werden, das Werkstück auf einer Trägerfläche abzusetzen, auf der es zunächst auf einem Luftkissen gelagert wird, so daß es zwischen zwei Überdruckzonen "schwimmt", bis ein Ausrichtvorgang beendet ist, z. B. zur Ausrichtung von im Werkstück befindlichen Löchern bezüglich aus der Lagerplatte ausgefahrener Stifte. Die Rückschlagventile 32A bis 32D und der Entlüftungskanal 40 erleichtern jeweils die Umschaltung des Kopfes von Unterdruck auf Überdruck und umgekehrt.

**Patentansprüche**

1. Vakuumkopf für flache, dünne Werkstücke, z. B. Platten, Folienelemente, Schriftgut und dgl., mit Abfühlvorrichtungen (50, 52) mit aus der Ebene der Anlagefläche (24) an der Unterseite des Vakuumkopfes (10) herausragenden, beweglichen Fühlstiften (56), dadurch gekennzeichnet, daß die an der Unterseite mit Öffnungen (25) versehene Anlagefläche (24) peripher zu einem zentralen Bereich (26) angeordnet und mit einer in bezug auf die Anlagefläche (24) zurückgesetzten Bodenwand (22) verbunden ist, die einerseits eine an Vakuum anschließbare Hauptkammer (16 bis 19) nach unten abschließt und andererseits gemeinsam mit einem an der Anlagefläche (24) anliegenden Werkstück in dem zentralen Bereich (26) eine Vakuumkammer bildet.

2. Vakuumkopf nach Anspruch 1, dadurch gekennzeichnet, daß die Hauptkammer in mehrere Teilkammern (16 bis 19) aufgeteilt ist.

3. Vakuumkopf nach den Ansprüchen 1 und 2, dadurch gekennzeichnet, daß der zentrale Bereich (26) mit der Hauptkammer (16 bis 19) durch die Einlaßrichtung schließende Rückschlagventile (32A bis 32D) verbunden ist.

4. Vakuumkopf nach Anspruch 1, dadurch gekennzeichnet, daß der zentrale Bereich (26) mittels eines Entlüftungsventils (40 bis 46) mit der Außenluft verbunden ist.

5. Vakuumkopf nach Anspruch 1, dadurch gekennzeichnet, daß zur Verbindung der Hauptkammer (16 bis 19) mit der Anlagefläche (24) als Drossel wirksame Bohrungen (27) angeordnet sind.

6. Vakuumkopf nach Anspruch 1, dadurch gekennzeichnet, daß die Fühlstifte (56) der Abfühlvorrichtungen (50, 52) an unterschiedlichen, definierten Positionen der Anlagefläche (24) angeordnet sind, an denen sie mit den korrespondierenden Löchern in einer bestimmten Gattung von Werkstücken ausgerichtet und mit Löchern in einer anderen Gattung von Werkstücken nicht ausgerichtet sind, und umgekehrt.

7. Vakuumkopf nach den Ansprüchen 1 und 6, dadurch gekennzeichnet, daß die Abfühlvorrichtungen (50, 52) mit einem Kopfteil (58) der Fühlstufte (56) zusammenwirkende Magnetjoche (60) zur Erzeugung elektrischer Positionssignale aufweisen.

**Claims**

1. Vacuum head for flat, thin workpieces, e.g. plates, foil elements, printed sheets etc, with sensor devices (50, 52) having movable sensor pins (56) protruding from the plane of the contact surface (24) at the lower side of the vacuum head (10), characterized in that the contact surface (24) having openings (25) at its lower side is arranged peripherally to a central area (26), and connected to a ground layer (22) sunk with respect to the contact surface (24), said ground layer closing, on the one hand, a main chamber (16 to 19) connectable to vacuum, and forming on the other, together with a workpiece resting against the contact surface (24), a vacuum chamber in the central area (26).

2. Vacuum head as claimed in claim 1, characterized in that the main chamber is divided into several partial chambers (16 to 19).

3. Vacuum head as claimed in claims 1 and 2, characterized in that the central area (26) is connected to the main chamber (16 to 19) through check valves (32A to 32D) closing the direction of entrance.

4. Vacuum head as claimed in claim 1, characterized in that the central area (26) is connected to the atmosphere by means of a venting valve (40 to 46).

5. Vacuum head as claimed in claim 1, characterized in that for connecting the main chamber (16 to 19) with the contact surface (24) borings (27) acting as throttle are arranged.

6. Vacuum head as claimed in claim 1, characterized in that the sensor pins (56) of the sensor devices (50, 52) are arranged at different defined positions of the contact surface (24), where they are aligned with the corresponding holes in a predetermined type of workpieces, and not aligned with holes in another type of workpieces, and vice versa.

7. Vacuum head as claimed in claims 1 and 6, characterized in that the sensor devices (50, 52) have magnetic yokes (60) co-operating with an upper portion (58) of the sensor pins (56), to produce electrical position signals.

**Revendications**

1. Tête à dépression pour pièces de travail planes et minces, telles que, par exemple, des plaques, des éléments en clinquant, des feuilles imprimées, etc., comportant des dispositifs de détection (50, 52) à doigts de détection mobiles (56) faisant saillies à partir du plan de la surface de contact (24) du côté inférieur de la tête à dépression (10), caractérisée en ce que la surface de contact (24) présentant des fentes (25) est disposée périphériquement à une zone centrale (26), et connectée à une paroi (22) située en retrait par rapport à la surface de contact (24), ladite paroi fermant, d'une part, une chambre principale (16 à 19) pouvant être raccordée à une source à dépression et formant, d'autre part, avec une pièce de travail posée sur la surface de contact (24), une chambre à dépression dans la zone centrale (26).

2. Tête à dépression selon la revendication 1 caractérisée en ce que la chambre principale est divisée en plusieurs chambres partielles (16 à 19).

3. Tête à dépression selon l'une des revendications 1 et 2 caractérisée en ce que la zone centrale (26) est raccordée à la chambre principale (16 à 19) par des soupapes d'arrêt (32A à 32D) fermant l'arrivée du fluide.

4. Tête à dépression selon la revendication 1 caractérisée en ce que la zone centrale (26) est raccordée à l'atmosphère par une soupape de mise à l'air libre (40 à 46).

5. Tête à dépression selon la revendication 1 caractérisée en ce que des trous (27) faisant fonction de régulateurs, sont prévus pour raccorder la chambre principale (16 à 19) à la surface de contact (24).

6. Tête à dépression selon la revendication 1, caractérisée en ce que les doigts de détection (56) des dispositifs de détection (50, 52) sont agencés en différents points définis de la surface de contact (24), de façon à être alignés avec des trous correspondants ménagés dans un type prédéterminé de pièces de travail et non alignés avec des trous ménagés dans un autre type de pièces de travail, et vice versa.

7. Tête à dépression selon les revendications 1 ou 6, caractérisée en ce que les dispositifs de détection (50, 52) présentent des culasses magnétiques (6) associées à la partie supérieure (58) des doigts de détection (56) pour générer des signaux de position électriques.

FIG. 1

FIG. 2

**FIG. 3**

52

62 50

60

58

56

**FIG. 5A**

38
37
47
36

24
25 22 26

**FIG. 4**

25
27
24

**FIG. 5B**

38
36 37
47

24
25 22 26